Europäisches Patentamt

European Patent Office

Office européen des brevets

(19)

(11) Publication number: 0 066 429
A2

# (12) EUROPEAN PATENT APPLICATION

(21) Application number: 82302613.3

(51) Int. Cl.³: G 11 C 5/00

(22) Date of filing: 21.05.82

(30) Priority: 22.05.81 JP 76503/81

(43) Date of publication of application:
08.12.82 Bulletin 82/49

(84) Designated Contracting States:
DE FR GB IT

(71) Applicant: Hitachi, Ltd.
5-1, Marunouchi 1-chome
Chiyoda-ku Tokyo 100(JP)

(72) Inventor: Minato, Osamu
Hitachi-Suzuki-Nitta Shataku B-6-3
1473, Josuihoncho Kodaira-shi(JP)

(72) Inventor: Masuhara, Toshiaki
2196-278 Hirai Hinodecho
Nishitama-gun Tokyo(JP)

(72) Inventor: Sasaki, Toshio
48-18, Akatsukicho-1-chome
Hachioji-shi(JP)

(72) Inventor: Sasaki, Yukio
Hitachi-Tokuraso 203 8-27, Tokura-1-chome
Kokubunji-shi(JP)

(72) Inventor: Kinoshita, Masami
Hitachi-Shoburyo 18-30, Midoricho-5-chome
Koganei-shi(JP)

(72) Inventor: Sakai, Yoshio
47-2-E304 Akatsukicho-1-chome
Hachioji-shi(JP)

(72) Inventor: Nagasawa, Kouichi
88-42 Yaho
Kunitachi-shi(JP)

(74) Representative: Ellis, Edward Lovell et al,
MEWBURN ELLIS & CO. 2/3 Cursitor Street
London EC4A 1BQ(GB)

(54) Semiconductor memory.

(57) A semiconductor memory wherein a semiconductor substrate (1) includes a well (3) of selected depth and of a conductivity type opposite to that of the substrate, a MOS transistor circuit constituting a memory cell formed in the surface region of the well and having information storage nodes the lower part of which is covered with an impurity region (30, 40, 56) of the same conductivity type as the well and being shallower in depth and higher in impurity concentration than the well.

FIG. 1

- 1 -

SEMICONDUCTOR MEMORY

The present invention relates to a monolithic semiconductor memory utilizing CMOS structure.

For reducing the power dissipazion of a monolithic memory, it is effective to adopt complementary MOS (which is referred to as CMOS, hereinafter) structure for the peripheral circuits formed on the same chip. In an example of such memory, a P type well is formed in a predetermined region of an N type substrate and an N-channel MOS transistor is formed in a surface region of the well, and a P-channel MOS transistor is formed in a surface region of the N type substrate, thereby to form a CMOS circuit with these N-channel and P-channel MOS transistors. On the other hand, a memory cell may be formed of a flip-flop of N-channel MOS transistors which are formed in another P type well independent of the P type well of the peripheral CMOS circuit.

The semiconductor memory as described above . has following advantages:

(1) The well for the memory cell section is separated and isolated from the well for the peripheral circuit section, thereby preventing the memory from the adverse effect of noise generated in the peripheral circuit at the time of switching and of noise induced through external terminals, and ensuring the normal operation of the memory.

(2) It is known that when an alpha particle or particles are emitted from the impurity in the packaging material of the memory device and irradiated on the chip surface of the semiconductor memory, informations stored in the storage nodes of the memory cells may be inverted to cause random errors (the so-called soft error). In the semiconductor memory of the kind described above, memory cells are formed in shallow wells having a thickness of at most 4 - 5 μm, while the electron-hole pair production by the alpha particle mainly occurs in deeper positions. Thus, the number of pairs generated in the well by the irradiation of alpha particle is very small (the number of electrons collected at a storage capacitor is 1/10 or below of the conventional memory having no well structure).

Recently, demand is increasing for higher packing density of a memory chip. As the size of the memory cell and thus the capacitance of storage nodes in the cell are made smaller in order to increase the packing density, electric charges stored or accumulated at the nodes become smaller, which results in an increase of occurrence of soft errors due to irradiation of alpha particles. If the resistance connected between the storage node and the power source for keeping the stored charges at the node is reduced, the occurrence of such soft error can be reduced. However, this method is not recommendable because it leads to an increase of power dissipation of the memory. According to another approach, such soft errors can be reduced by decreasing the diffusion depth of the P type well, since shallower well means less generation of the electrons and holes within the well at the time of alpha ray radiation. Shallower diffusion depth of the P type well, however, will cause an increase in the current amplification factor $h_{FE}$ of a parasitic bipolar transistor the base of which is formed of the P type well. That is, the parasitic transistor effect will develop strongly and this effect may sometimes obstruct the normal operation of the memory. For example, noise arrived at the P type well in the CMOS structure may cause a parasitic thyristor in the CMOS structure to be turned on, whereby a latch-up phenomenon occurs and the operation of the CMOS circuit stops.

Accordingly, it is an object of the present invention to provide a monolithic memory which reduces the occurrence of soft errors resulting from alpha ray radiation and can prevent the faulty operation due to the parasitic transistor effect.

Another object of the present invention is to provide a monolithic memory of a high packing density, low power dissipation and high reliability.

According to one of the features of the invention, there is provided a semiconductor memory formed in a semiconductor substrate, wherein a well of a predetermined depth and of a conductivity type opposite to that of the substrate is formed in part of the substrate, a MOS transistor circuit constituting a memory cell is formed in a surface region of the well, and at least a lower part of an information storage node of said circuit is covered with an impurity region having a higher impurity concentration of the same conductivity type as that of the well and a depth shallower than that of the well.

According to another feature of the invention, there is provided a semiconductor memory formed in a semiconductor substrate, wherein the memory cell is formed in a surface region of a double-well structure which comprises a first impurity region of a conductivity type opposite to that of the substrate and of a predetermined depth below the substrate surface, and a second impurity region shallower in depth and higher in impurity concentration than the first impurity zone, the first and second regions being located at substantially the same area of the substrate.

By providing such a region of higher impurity concentration near the surface of the semiconductor substrate, carriers generated by irradiation of alpha particles can be prevented from reaching the storage node of the memory cell. Therefore, even if the storage node has a small capacitance, soft errors can be suppressed. Further, since formation of memory cells within a region of a higher impurity concentration leads to an increase of the capacitance of the storage node, the memory can have a high packing density and a sufficient node capacitance. Furthermore, since the well itself has a sufficiently large thickness or depth, the effect of the parasitic bipolar transistor whose base is formed of the well can be sufficiently decreased. Whereby, a memory with a high reliability can be obtained.

The above and other objects, features and advantages of the present invention will be apparent from the following detailed description taken in conjunction with the accompanying drawings, in which:

Fig. 1 is a partial cross-sectional veiw of a semiconductor memory according to an embodiment of the present invention;

Fig. 2A is an equivalent circuit of a memory cell portion of the memory of Fig. 1;

Fig. 2B is a top view of the memory cell portion of Fig. 1;

Fig. 3 is a partial cross-sectional view of a memory according to another embodiment of the present invention;

Fig. 4A is a partial cross-sectional view of a memory according to another embodiment of the present invention;

Fig. 4B is an equivalent circuit of the memory cell of Fig. 4A; and

Fig. 5 is a partial cross-sectional view of a peripheral circuit of an embodiment of the present invention.

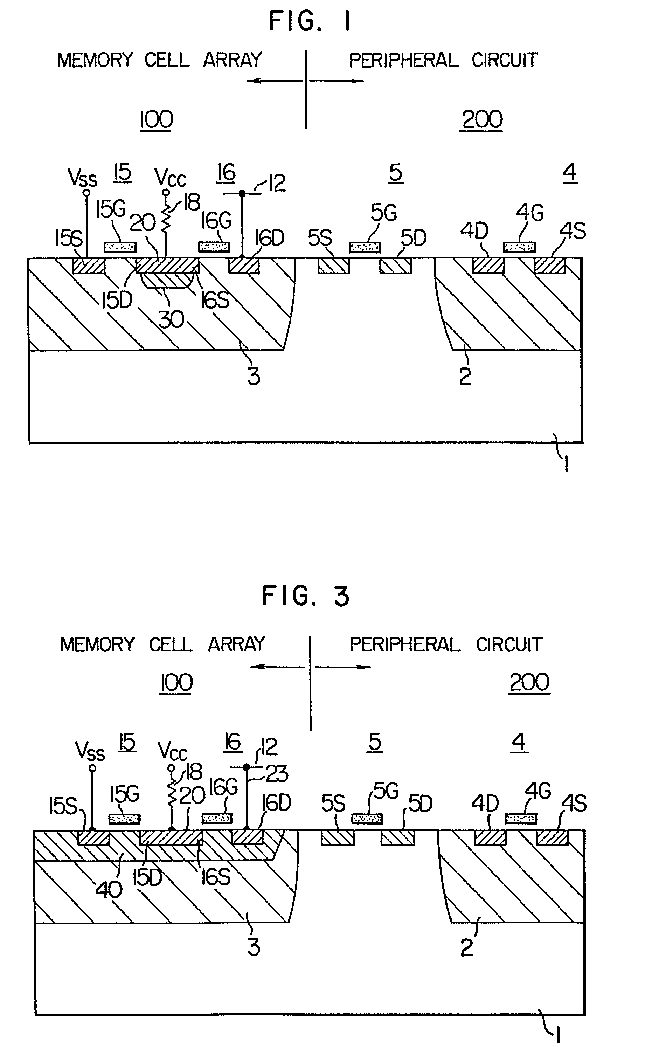

Referring now to Fig. 1, there is shown a partial cross-sectional view of a static MOS memory chip in accordance with an embodiment of the present invention. In a surface region of a silicon (Si) substrate 1 of N type conductivity and of low impurity concentration, are formed a $P^+$ region 5S serving as a source, and a $P^+$ region 5D serving as a drain, which constitute a P-channel MOS transistor 5 together with a gate 5G formed of a doped polycrystalline silicon layer. In part of the substrate, are further formed P type wells 2 and 3 having an impurity concentration of $10^{15}$ $cm^{-3}$. The P type well 2 further contains at its surface portion an N type source region 4S and an N type drain region 4D, which form an N-channel MOS transistor 4 together with a gate 4G made of polycrystalline silicon. The MOS transistors 4 and 5 form part of a peripheral circuit 200 of the memory. More specifically, for example, the gates 4G and 5G are connected to an input terminal, drains 4D and 5D are connected to an output terminal, the sources 5S and 4S are used as a power supply terminal and a ground terminal, respectively. Whereby, a CMOS inverter circuit can be formed with these P-channel and N-channel MOS transistors. Such an inverter has an advantage that it dissipates electric power only during transition of the switching operations.

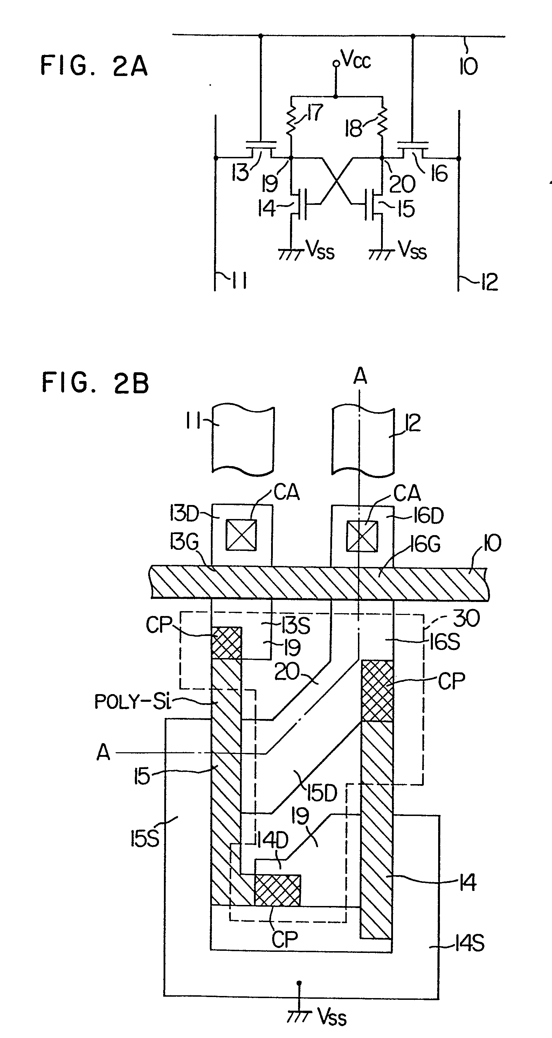

On the other hand, a memory cell array 100 is formed within the P type well 3 separated or isolated from the P type well 2. In Fig. 1, there are shown only two N-channel MOS transistors 15 and 16. The N-channel MOS transistor 15 comprises an N type region 15S (a source), an N type region 15D (a drain) and a polycrystalline silicon gate 15G. The P-channel MOS transistor 16 comprises an N type region 16S (a source), an N type region 16D (a drain) and a polycrystalline silicon gate 16G. The transistors 15 and 16 form a portion of a memory cell shown in Figs. 2A and 2B. A P-type layer 30 of a higher impurity concentration that that of the well 3 is provided under a storage node 20 of the memory cell.

The structure of the memory cell will be described in further detail referring to Figs. 2A and 2B which respectively show an equivalent circuit and a top view of the memory cell. The cell comprises the N-channel MOS transistors 14 and 15 serving as drivers of a flip-flop circuit, the N-channel MOS transistors 13 and 16 serving as transfer gates, and resistances 17 and 18 (omitted in Fig. 2B) connected to a voltage source $V_{cc}$. Part of the polycrystalline silicon layer which constitutes a word line 10 concurrently serves as the gates 13G and 16G of the MOS transistors 13 and 16. The drains 13D and 16D of the MOS transistors 13 and 16 are connected to data lines 11 and 12, respectively, which are made of aluminum layers. Reference symbol CA designates a contact area between the Al layer and the $N^{+}$ region. A source 13S of the MOS transistor 13 and a drain 14D of the MOS transistor 14 are interconnected by a polycrystalline layer which also forms the gate 15G of the MOS transistor 15. This portion corresponds to a storage node 19. Reference symbol CP denotes a contact area between the polycrystalline silicon layer and the $N^+$ region. The source 16S of the MOS transistor 16 and the drain 15D of the MOS transistor 15 are formed of a continuous $N^+$ type region. The $N^+$ region is coupled to a polycrystalline silicon layer which forms a gate 14G of the transistor 14. This portion forms another storage node 20 of the memory cell. The storage nodes 19 and 20 are connected to the supply voltage $V_{cc}$ respectively via the resistances 17 and 18 (not shown in Fig. 2B). A source 14S of the transistor 14 and the source 15S of the transistor 15 are both connected to a common line (not illustrated in Fig. 2B) whose potential is $V_{ss}$. It will be noted from the above explanation that the memory cell array portion on the left side in Fig. 1 corresponds to the cross-sectional view taken along line A-A' in Fig. 2B. The P type impurity layer 30 with a higher impurity concentration than that of the P-well 3 is provided under the N type regions constituting the storage nodes 19 and 20 so as to cover most of the lower surface of the N type region. The P type region 30 does not extend to the channel regions below the gates as can be seen in Fig. 2B. Thus, the threshold voltage is not altered by the presence of the P type region 30 in this embodiment. In an example, the P type well 3 had a depth of 4 μm and the P type region 30 of higher impurity concentration had a depth of 1 μm from the semiconductor surface. Also, the P type well 3 and the P type impurity region 30 had respective impurity concentrations of $1 \times 10^{15}$ cm$^{-3}$ and $1 \times 10^{17}$ cm$^{-3}$. Impurity concentration of the N type regions constituting the storage nodes 19 and 20 was $10^{21}$ cm$^{-3}$. Presence of the P type impurity region 30 of higher impurity concentration will increase about twice the junction capacitance of the nodes 19 and 20 and correspondingly increase the amount of memory cell storage charge. The difference in impurity concentration between the P type well 3 and the P type region 30 of higher impurity concentration will provide a potential difference of about 0.13 volts therebetween at the room temperature. The electric field resulting from the potential difference prevents electrons generated in the P type well by the irradiation of alpha particles from reaching the N$^{+}$ type regions of the nodes 19 and 20. Whereby, the occurrence of soft errors can be remarkably reduced. The P type well has a thickness or depth sufficient to suppress the parasitic transistor effect and hence to prevent such an abnormal phenomenon as latch-up.

It is preferable that the impurity concentration ratio between the P type impurity region 30 and the P type well 3 is not smaller than 100 for providing effects as described above.

For example, the impurity concentration of the P type region 30 may be raised to about $1 \times 10^{18}$ cm$^{-3}$. Then, the potential difference between the P type region 30 and the P type well 3 is raised to about 0.18 volt, provided that the impurity concentration of the P type well 3 is maintained at $1 \times 10^{15}$ cm$^{-3}$. The raised potential difference assures fewer occurrence of soft errors. However, the impurity concentration of the P type impurity region 30 should be so selected as to allow the application of a voltage within the rated supply voltage of the semiconductor memory device. Namely the junctions between the N type regions of the nodes 19 and 20 and the P type impurity region 30 should not be broken down by the application of rated voltages.

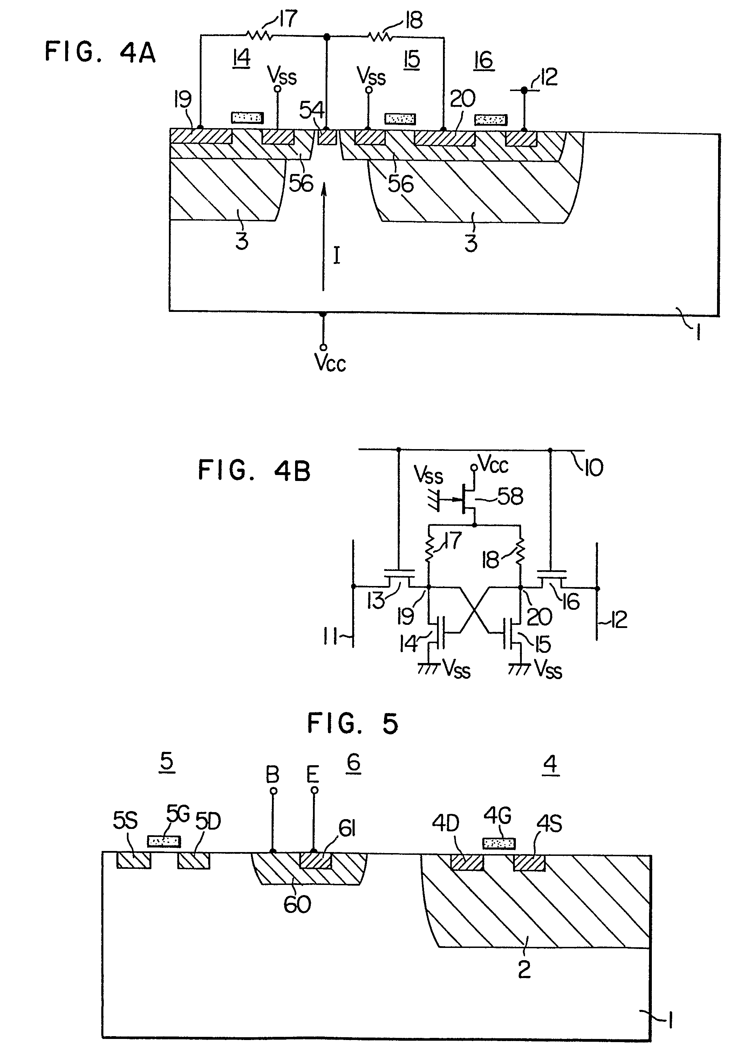

Fig. 3 is a cross-sectional view of part of a static memory chip according to a second embodiment of the present invention. The structure of Fig. 3 is different from the embodiment of Fig. 1 in that all elements in the memory of Fig. 3 are surrounded by a P type impurity layer 40 of higher impurity concentration than that of the P type well, in other words, the memory cell is in the form of a double-well structure which consists of a first deeper well 3 of lower impurity concentration and a second shallower well 40 of higher impurity concentration. Like reference numerals or symbols denote like or equivalent parts in Figs. 1 and 3. In the embodiment shown in Fig. 1, electrons generated by alpha particles may reach the N type regions of the node through the side thereof which is not covered with the P type impurity layer 30, to thereby extinguish or destroy the charge stored in the memory cell. Even in the data line which has a far larger capacitance than the storage capacitance of the memory cell, when a potential difference between two data lines is reduced for achieving a higher speed operation, undesirable soft errors might occur due to the electrons generated by alpha particles.

In the embodiment of Fig. 3, on the other hand, the above problem remaining in the embodiment of Fig. 1 can be resolved and thus unfavourable soft errors can be more perfectly prevented. In this case, since the threshold voltages $V_{th}$ for the MOS transistors 15 and 16 formed in the double-well structure depends upon the impurity concentration of the P type higher impurity layer 40, the selection of the impurity concentrations should be made considering this point. In order to control the threshold voltage of the MOS transistor 4 formed in the P type well 2 in association with the threshold voltage of the MOS transistors 15 and 16, a proper amount of impurity ions may be preferably doped into the channel region opposing to the gate 4G in the transistor 4.

Figs. 4A and 4B show a third embodiment of the present invention. In the first and second embodiments shown in Figs. 1 and 3, currents are supplied to respective storage nodes of the memory cell via wirings such as Al lines disposed on the semiconductor substrate. In this embodiment, currents are supplied to respective memory cell through the substrate, utilizing the fact that the substrate itself is at the supply potential $V_{cc}$ (as is usual in operating a CMOS circuit of usual CMOS structure).

Fig. 4A shows a cross-section of the memory cell of double-well structure wherein the P type well 3 has an aperture or opeting (non-diffused area) at a predetermined portion. Another P type layer 56 higher in impurity concentration and shallower in depth than the well 3 is formed to be superposed on the well 3. This P type layer 56 has also an aperture at the simialr locazion so as to expose the N type substrate 1 having a low concentration thereat. At a central portion of the exposed N type region, an N type region 54 of a high impurity concentration is formed. The N type region 54 is connected with the resistances 17 and 18. The other ends of the resistances 17 and 18 are connected respectively to storage nodes 19 and 20 of the memory cell. The equivalent circuit of the memory cell of Fig. 4A is given in Fig. 4B. The structure of the MOS transistors 13 to 16 in the memory cell of Fig. 4A is the same as that in the memory cell of Fig. 3, except that a current I is supplied from the supply voltage $V_{cc}$ to the storage nodes 19 and 20 via the substrate 1, the N type region 54, and the resistances 17 and 18. Here, the P type well 3 and P type higher impurity layer 56 are both set at the ground potential $V_{ss}$. Thereby, a junction field effect transistor (J-FET) 58 (see Fig. 4B) is formed which has a drain formed of the substrate 1, a source formed of the N type region 54 and a gate formed of the P type well 3 and P type layer 56.

The dimensions of the central aperture area provided in the P type well 3 should preferably 8 μm x 8 μm or more, when taking into consideration the lateral diffusion in the course of forming the well 3 and the margin for the depletion layer formed by a reverse biasing between the well 3 and the substrate 1. The dimensions of the central aperture area provided in the P type impurity layer 56 can be reduced down to about 3 μm x 3 μm when the P type impurity layer 56 has a thickness or depth of 1 μm. As has been described above, formation of the memory cells in the double-well structure will enable reduction of the aperture area necessary to supply currents to the cells. Further, since the thin P type impurity layer 56 of higher impurity concentration is covered on most of its bottom surface with the thick P type well 3, the parasitic transistor effect can be suppressed. A common aperture area may be provided for each group of a plurality of memory cells to supply currents dispersedly to the respective cells for saving the substrate area.

In the peripheral circuit 200 of the embodiments described in the foregoing, bipolar transistors may be mixed with the CMOS circuit. In this connection, if a P type region 60 used as a base of a bipolar transistor 6 is formed under the same conditions as those for forming the impurity layer of higher impurity concentration, then the bipolar transistor 6 can have a high current amplification factor $h_{FE}$, as shown in Fig. 5. In Fig. 5, an N type region 61 is used as an emitter of the bipolar transistor and the substrate 1 is used as a collector thereof. Like reference numerals or symbols denote like parts in the figures. It goes without saying that in the case where such a structure as in Fig. 5 is employed for the peripheral circuit, means must be provided for eliminating or suppressing a latch-up phenomenon resulting from the CMOS structure. The elimination or suppression of latch-up can be achieved, for example, by spacing the drain 5D of the P-channel MOS transistor 5 from the base 60 of the bipolar transistor 6 to thereby reduce the current amplification factor $h_{FE}$ of a lateral parasitic bipolar transistor undesirably formed bewteen the drain 5D and the base 60; by providing a highly-doped N type impurity layer between the zone 5D and the base zone 60 or around the semiconductor zone 60 and fixing the same at the supply voltage level and lowering the base resistance of the above parastic bipolar transistor to thereby prevent variations in the base potential thereof; or by arranging the peripheral circuit so as to prevent undesirable interference of surge and noise with the emitter and base terminals of the bipolar transistor.

CLAIMS :-
(~~WHAT IS CLAIMED IS.~~)

1.      A semiconductor memory comprising:

a semiconductor substrate (1) of a first conductivity type;

a first impurity region (3) formed in a surface region of said semiconductor substrate and having a second conductivity type opposite to said first conductivity;

second impurity regions (15S, 15D, 16S, 16D) formed in said first impurity region and having the first conductivity type, the second impurity regions constituting a source and a drain of a first insulated-gate field effect transistor of a memory circuit and including a storage node of the memory circuit; and

a third impurity region (30, 40, 56) of the second conductivity type having an impurity concentration higher than that of said first impurity region and formed shallower than said first impurity region, the third impurity region substantially covering at least the bottom surface of said second impurity region serving as the storage node.

2.      A semiconductor memory according to claim 1, wherein the impurity concentration of said third impurity region is at least 100 times large as that of said first impurity region.

3.      A semiconductor memory according to claim 1, wherein said third impurity region extends substantially the same surface region of the substrate as said first impurity region.

4.        A semiconductor memory according to claim 3, wherein said first and third impurity regions have a common aparture to expose said substrate.

5.        A semiconductor memory according to claim 4, wherein the aperture of said third impurity region has a smaller area than that of the aperture of said first impurity region and substantially defines the area of said exposed substrate.

6.        A semiconductor memory having at least one first insulated gate field effect transistor (13, 14, 15, 16), comprising:

        a semiconductor substrate (1) of a first con-ductivizy type;

        a first impurity region (3) of a second conductivity type opposite to said first conductivity type;

        a second impurity region (30 or 40) of the second conductivity type provided in said first impurity region, said second impurity region being higher in impurity concentration and shallower in depth than said first impurity region; and

        third impurity regions (15S, 15D, 16S or 16D) of the first conductivity type provided within said second impurity region and forming a source (15S) and a drain (15D) for said transistor.

7.        A semiconductor memory as set forth in claim 6, further comprising:

a fourth impurity region of the second conductivity type formed in a surface region of said substrate;

fifth impurity regions (4S and 4D) of the first conductivity type provided within said fourth impurity region (2) and constituting a source and a drain of a second insulated-gate field effect transistor; and

sixth impurity regions (5S and 5D) of the second conductivity type provided in surface regions of said substrate and constituting a source and a drain of a third insulated field effect transistor, the second and the third field effect rransistors forming a complementary circuit.

8.      A semiconductor memory as set forth in claim 7 wherein said at least one first insulated gate field effect transistor (13, 14, 15, 16) constitutes a memory circuit (100) and said complementary circuit (200) constitutes a peripheral circuit (4).

9.      A semiconductor memory as set forth in claim 8 wherein said memory circuit (100) forms a static memory circuit including a flip-flop circuit (14, 15) as a unit circuit.

10.      A semiconductor memory as set forth in claim 8, wherein said substrate is adapted to be maintained at a predetermined power source potential ($V_{cc}$) and said first impurity region (3) is adapted to be kept at a common potential ($V_{ss}$).

11.      A semiconductor memory as set forth in claim 9, wherein said first and third impurity regions (3, 30, 40, 56) are provided respectively with apertures to expose a first conductivity type region at the surface of said semiconductor substrate (1).

12.      A semiconductor memory as set forth in claim 7, further comprising:

a seventh impurity region (60) having substantially the same depth and impurity concentration as said second impurity region (30, 40) and serving as a base of a bipolar transistor of a driver circuit.

# FIG. I

MEMORY CELL ARRAY | PERIPHERAL CIRCUIT

100      200

# FIG. 3

MEMORY CELL ARRAY | PERIPHERAL CIRCUIT

100      200

FIG. 2A

FIG. 2B

FIG. 4A

FIG. 4B

FIG. 5